# EUROPÄISCHE PATENTSCHRIFT

(11) **EP 0 906 717 B1**
(45) Veröffentlichungstag und Bekanntmachung des Hinweises auf die Patenterteilung: **27.09.2000**
(21) Anmeldenummer: 97930305.4
(22) Anmeldetag: 06.06.1997
(51) Int. Cl.: H05K 7/14

(54) **BAUGRUPPENTRÄGER MIT ZENTRIERBARE FRONTPLATTEN AUFWEISENDEN, EINSTECKBAREN BAUGRUPPEN**
SUBASSEMBLY RACK WITH PLUGGABLE SUBASSEMBLIES COMPRISING FRONT PLATES THAT CAN BE CENTRED
CHASSIS DE MONTAGE DE SOUS-ENSEMBLES ENFICHABLES POURVUS DE PLAQUES FRONTALES POUVANT ETRE CENTREES

(30) Priorität: 18.06.1996 DE 29610693 U
(43) Veröffentlichungstag der Anmeldung: 07.04.1999
(73) Patentinhaber: SIEMENS AKTIENGESELLSCHAFT, 80333 München (DE)
(72) Erfinder: BILLENSTEIN, Ernst, D-91593 Burgbernheim (DE); KÖRBER, Werner, D-91282 Betzenstein (DE); KURRER, Siegfried, D-90449 Nürnberg (DE); SCHAFFER, Kurt-Michael, D-90542 Eckental (DE)
(86) Internationale Anmeldenummer: DE9701146
(87) Internationale Veröffentlichungsnummer: WO9749270

(56) Entgegenhaltungen:
- EP-A- 0 527 608
- DE-A- 2 348 170
- DE-C- 4 130 355
- FR-A- 2 599 927

## Beschreibung

Bei Baugruppenträger bilden die metallischen Frontplatten von einsteckbaren Baugruppen eine in der Regel elektromagnetisch abschirmende, geschlossene Frontseite. Dabei sind die Spalten zwischen den einzelnen Frontplatten der Baugruppen in der Regel durch an der jeweiligen Frontplatte angeordnete Kontaktfederelemente elektromagnetisch abschirmend überbrückt. Ein Problem besteht darin, daß die Frontplatten durch die aufgrund der Kontaktfederelemente erzeugten horizontalen Seitenkräfte zwischen den Spalten leicht verschoben werden können. Durch Summierung des Versatzes der Frontplatten kann eine einzelne Öffnung eine zu geringe Breite aufweisen. Eine zwischen einer Mehrzahl von bereits eingeschobenen Baugruppen zuletzt einzuschiebende Baugruppe ist somit nicht mehr oder unter der Gefahr einer Beschädigung der Kontaktfederelemente in den Baugruppenträger einschiebbar.

Aus der FR 2 599 927 ist ein Frontelement für einen Baugruppenträger bekannt, welcher Querverbindungsschienen aufweist. Die Zentrierung einer Frontplatte an einer Querverbindungsschiene wird dadurch bewirkt, daß eine Seitenfläche an der Frontplatte einen Vorsprung an der Querschiene hintergreift, so daß Stirnflächen der Frontplatte paßgenau auf einer Oberseite der Querverbindungsschiene zu liegen kommen. Zur anschließenden Befestigung der Frontplatte an der Querverbindungsschiene ist eine Befestigungsschraube vorgesehen.

Aus der DE 41 30 355 C1 und dem Katalog "europac lab HF, EMC Schroff, D 9/94 7/7 (39600-100)" der Firma Schroff GmbH ist ein Baugruppenträger für mit Frontplatten versehene Steckmodule bekannt. An zwei vorderen Modulschienen sind längs angeordnete, äquidistante Gewindelöcher zum Anschrauben der Frontplatten angebracht. Dabei weisen die Frontplatten oben und unten mindestens eine Befestigungsschraube auf. Neben den Befestigungsschrauben ist an der Rückseite der Frontplatten wenigstens ein zusatzlicher Zentrierstift angeordnet. Diese Zentrierstifte tauchen beim Einschieben eines Steckmoduls in vor den Gewindelöchern angeordnete Zentrierlöcher ein und dienen zur Positionierung der einzelnen Frontplatten in der dafür vorgesehenen Position des jeweiligen Steckplatzes am Baugruppenträger.

Nachteilig ist, daß neben den Befestigungsschrauben zusätzlich Zentrierstifte an der Rückseite der Frontplatten angebracht sind. Diese Zentrierstifte müssen dabei positionsgenau in die Frontplatten eingepreßt werden, da insbesondere beim Strangpressen der Frontplatten die Zentrierstifte nicht mitangeformt werden können. Dadurch entsteht unvorteilhaft ein erhöhter Materialaufwand und es ist insbesondere eine erhöhte Anzahl an Fertigungsschritten zur Herstellung der Frontplatten notwendig.

Aufgabe der Erfindung ist es, einen Baugruppenträger mit Frontplatten aufweisenden Baugruppen auf eine weniger aufwendige Art und Weise so zu gestalten, daß die Baugruppen am Baugruppenträger ausreichend positionierbar und somit problemlos ein- und aussteckbar sind.

Die Aufgabe wird gelöst mit dem im Anspruch 1 angegebenen Baugruppenträger.

Vorteil des erfindungsgemäßen Baugruppenträgers ist die erfindungsgemäße Gestaltung der Frontplatte mit den diese durchreichenden Schrauben. Die Schrauben sind bevorzugt in Form von Schaftschrauben ausgeführt, welche so in die Frontplatte eingepaßt sind, daß in radialer Richtung nahezu keine Beweglichkeit, d.h. kein "Spiel" besteht, die Schaftschrauben aber noch drehbar und in Axialrichtung verschiebbar sind.

Besonders vorteilhaft ist es, daß die Schaftschrauben der Frontplatten erfindungsgemäß zwei Funktionen gleichzeitig übernehmen. Beim Einstecken der Baugruppe in den Baugruppenträger wird die Frontplatte durch die Schaftschrauben gleichzeitig zentriert und kann anschließend durch dieselben Schaftschrauben zusätzlich am Baugruppenträger positionsgenau fixiert werden.

Vorteilhaft ist desweiteren der geringere Fertigungsaufwand für die Frontplatten bei der Herstellung des erfindungsgemäßen Baugruppenträgers.

Weitere vorteilhafte Ausführungsformen der Erfindung sind in den entsprechenden Unteransprüchen angegeben.

Die Erfindung wird desweiteren anhand des in den nachfolgend kurz angeführten Figuren dargestellten Ausführungsbeispieles weiter erläutert. Dabei zeigt
- FIG 1: beispielhaft eine perspektivische Seitenansicht einer Frontplatte einer einschiebbaren Baugruppe mit einer vorderen Querschiene eines erfindungsgemäßen Baugruppenträgers,
- FIG 2: beispielhaft eine Schnittdarstellung einer vorderen Querschiene eines erfindungsgemäßen Baugruppenträgers mit der Frontplatte einer in diesen eingeschobenen Baugruppe, welche durch die Schaftschraube erfindungsgemäß positioniert wird, und
- FIG. 3: beispielhaft eine Schnittdarstellung des bereits in der Figur 2 dargestellten erfindungsgemäßen Baugruppenträgers mit angeschraubter Frontplatte.

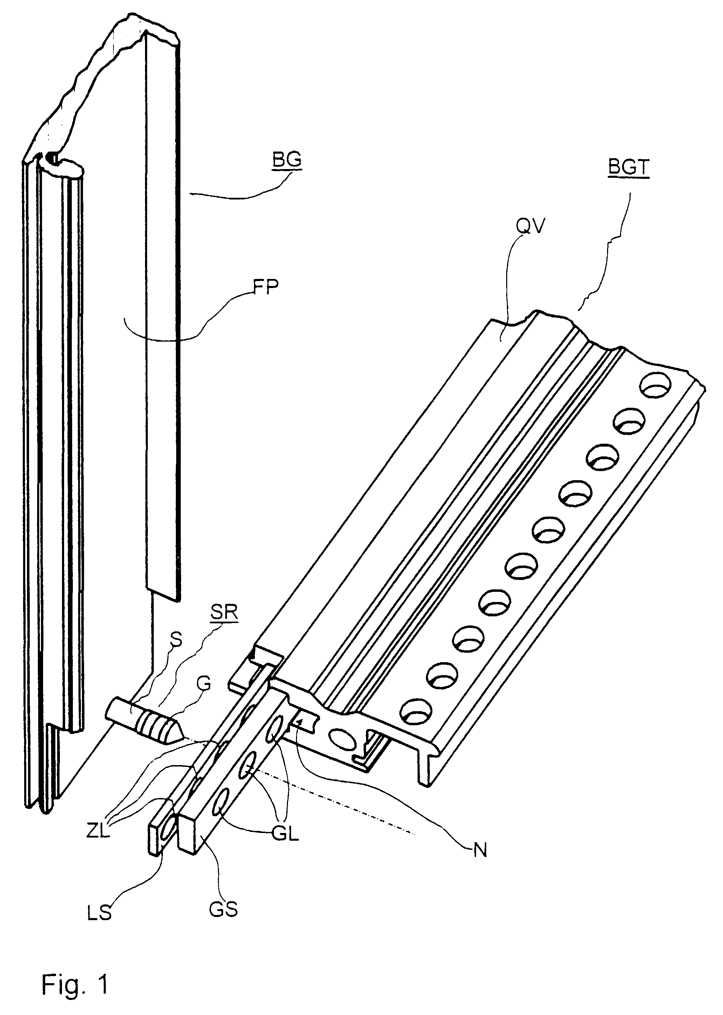

In Figur 1 ist beispielhaft eine perspektivische Seitenansicht einer Frontplatte FP einer Baugruppe BG und einer "aufgeschnittenen" unteren vorderen Querschiene QV eines Baugruppenträgers BGT dargestellt. Der Baugruppenträger BGT weist dabei in der Regel zwei vordere Querschienen QV auf, welche insbesondere zum Anschrauben der Frontplatte FP mittels Schrauben dienen. Vorteilhaft können die Schrauben als Schaftschrauben SR ausgebildet sein. Die Querschienen QV weisen dabei Führungsmittel auf, welche zur Zentrierung und Fixierung der Schrauben der Frontplatten FP dienen. Die Querschiene QV weist bevorzugt längs in Reihe angeordnete Führungsmittel auf, welche in Figur 1 durch die Bezugszeichen N, LS, ZL, GS und GL gekennzeichnet sind. Ein derartiges Führungsmittel weise jeweils einen durch LS und ZL gekennzeichneten vorderen Zentrierbereich, und einen durch GS und GL gekennzeichneten hinteren Gewindebereich auf.

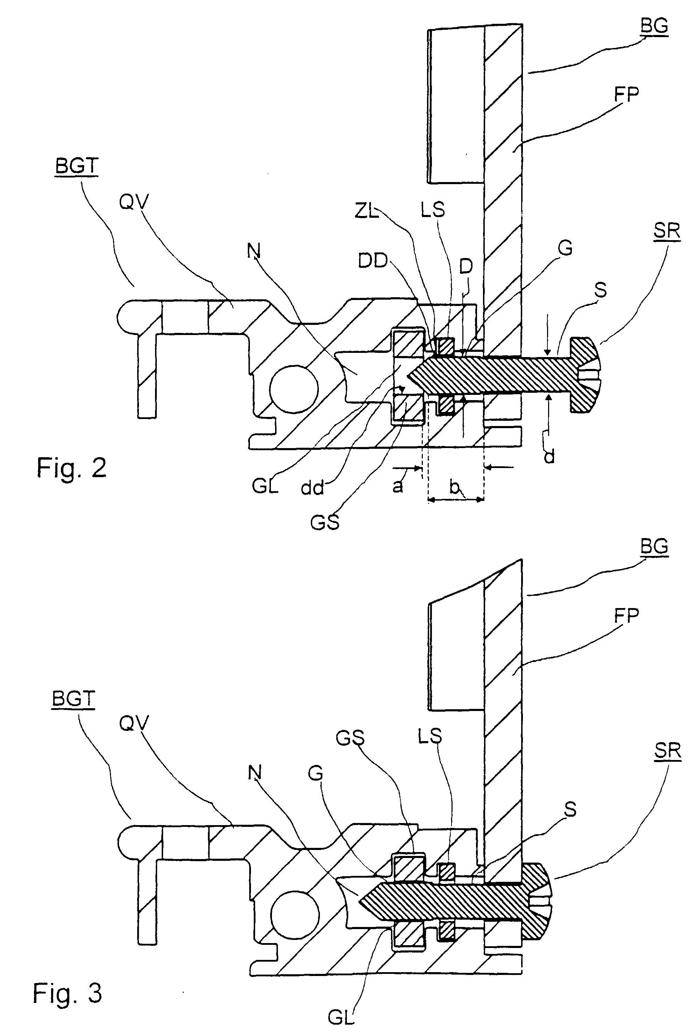

Insbesondere können die Führungsmittel eine Zentrierleiste LS aufweisen, in welcher zur Bildung des vorderen Zentrierbereichs längs in Reihe angeordnete äquidistante Zentrierlöcher ZL vorgesehen sind. Desweiteren können die Führungsmittel eine Gewindeleiste GS aufweisen, welche hinter der Zentrierleiste LS angeordnet ist und in welcher zur Bildung des hinteren Gewindebereichs längs in Reihe angeordnete äquidistante Gewindelöcher GL vorgesehen sind. Dabei weisen die Führungsmittel insbesondere eine zu der Frontplatte FP hin offene, profilierte Längsnut N in der Querschiene QV auf, in welche die Zentrierleiste LS und die Gewindeleiste GS eingeschoben sind. Wie in der Figur 2 dargestellt ist, weisen die Zentrierlöcher ZL insbesondere einen Durchmesser DD auf, welcher größer ist als der Gewindedurchmesser dd der Gewindelöcher GL. In einer nicht weiter dargestellten Ausführungsform sind die Zentrierleiste LS und die Gewindeleiste GS einstückig hergestellt. Beispielsweise können die Führungsmittel aber auch in Form von nicht dargestellten, vorne in die Querschienen QV eingebrachten Bohrungen vorliegen.

Gemäß einer vorteilhaften weiteren Ausführungsform der Erfindung ist die Schraube, wie in Figur 1 dargestellt ist, in Form einer Schaftschraube SR mit einem Schaftteil S und einem Gewindeteil G ausgeführt. Die Schaftschraube SR ist dabei so an die Frontplatte FP angepaßt, daß der Schaftteil S erfindungsgemäß einerseits die Frontplatte FP annähernd paßgenau durchreicht und somit nahezu keinen radialen Bewegungsspielraum aufweist. Andererseits ist der Schaftteil S aber noch in der Frontplatte FP drehbar und nahezu ausschließlich axial beweglich. Wie in der Figur 2 dargestellt ist, weist das Gewindeteil G insbesondere einen Gewindeaußendurchmesser D auf, welcher größer ist als der Schaftdurchmesser d des Schaftteils S.

In Figur 2 ist beispielhaft eine Schnittdarstellung der vorderen Querschiene QV eines Baugruppenträgers BGT dargestellt, wobei die Frontplatte FP einer eingeschobenen Baugruppe BG durch die Schaftschraube SR erfindungsgemäß zentriert ist. Beim Anlegen der Frontplatte FP an die Querschiene QV reicht der Gewindeteil G der Schaftschraube SR erfindungsgemäß in ein Zentrierloch ZL der Zentrierleiste LS und zentriert somit die Frontplatte FP in Radialrichtung. Vorteilhaft ist der Gewindeaußendurchmesser D des Gewindeteils G der Schaftschraube SR deshalb insbesondere geringfügig kleiner als der Durchmesser DD der Zentrierlöcher ZL. Der Gewindeteil G der Schaftschraube SR wird somit erfindungsgemäß bereits nahezu radial unbeweglich im Zentrierloch ZL zentriert. Der Gewindeteil G weist dabei insbesondere eine Länge b auf, welche geringfügig kleiner ist, als der Abstand a der Gewindeleiste GS von der an die Querschiene QV angelegten Frontplatte FP. Der Gewindeteil G der Schaftschraube SR kann somit erfindungsgemäß im Zentrierloch ZL bereits zur Zentrierung der Frontplatte FP dienen, bevor dieser in das Gewindeloch GL der Gewindeleiste GS eingedreht wird.

Durch das von den äquidistant angeordneten Zentrierlöchern ZL und Gewindelöchern GL vorgegebene Raster ist die Frontplatte FP einer Baugruppe BG diesem Raster entsprechend beliebig an unterschiedlichen Steckplätzen des Baugruppenträgers BGT positionierbar. Dies ist insbesondere von Vorteil bei Baugruppenträgern BGT, in welche häufig Baugruppen BG mit unterschiedlichen Dicken eingeschoben werden und die übrigen dementsprechend verschoben neu eingesteckt werden müssen.

Wie in Figur 3 dargestellt ist, ist die Frontplatte FP nach dem in Figur 2 bereits dargestellten Anlegen an einer vorderen Querschiene QV des Baugruppenträgers BGT anschließend erfindungsgemäß durch dieselbe, mittels der Zentrierleiste LS zur Zentrierung der Frontplatte FP dienenden Schaftschraube SR an der Querschiene QV fest anschraubbar. Der Gewindeteil G der Schaftschraube SR ist dabei zusätzlich in das hinter dem Zentrierloch ZL angeordnete Gewindeloch GL der Gewindeleiste GS einschraubbar. Erfindungsgemäß übernimmt die Schaftschraube SR somit vorteilhaft zum einen die Funktion der Positionierung der Frontplatte FP beim Einstecken der Baugruppe BG in den Baugruppenträger BGT und zum anderen dient dieselbe Schaftschraube SR zusätzlich zur Befestigung der Frontplatte FP am Baugruppenträger BGT.

Bevorzugt weist eine Frontplatte FP sowohl im oberen als auch im unteren Endbereich wenigstens eine Schaftschraube SR auf, um die Frontplatte FP der Baugruppe BG an einer oberen und unteren vorderen Querschiene QV des Baugruppenträgers BGT zu befestigen.

Vorteil der Erfindung ist, daß die Schaftschrauben SR einer Frontplatte FP erfindungsgemäß zwei Funktionen gleichzeitig übernehmen. Beim Einstecken der Baugruppe BG in den Baugruppenträger BGT wird die Frontplatte FP durch die Schaftschrauben SR gleichzeitig zentriert und ist anschließend durch dieselben Schaftschrauben SR zusätzlich am Baugruppenträger BGT positionsgenau anschraubbar. Dadurch ist vorteilhaft eine Vielzahl von Baugruppen BG nebeneinander ohne gegenseitige Behinderung in den Baugruppenträger BGT einschiebbar.

## Patentansprüche

1. Baugruppenträger (BGT) mit einsteckbaren Baugruppen (BG), welche mit einer Frontplatte (FP) versehen sind, und mit
a) wenigstens einer vorderen Querschiene (QV) zum Anschrauben der Frontplatte (FP), wobei die Querschiene (QV) Führungsmittel (N, LS, ZL, GS, GL) mit jeweils einem vorderen Zentrierbereich (LS, ZL) und einem hinteren Gewindebereich (GS, GL) aufweist, und mit
b) wenigstens einer die Frontplatte (FP) einer Baugruppe (BG) durchreichenden Schraube (SR), wobei zumindest Frontplatte (FP) und Schraube (SR) derart aufeinander abgestimmt sind, daß
b1) die Schraube (SR) bei Anlegen der Frontplatte (FP) an die Querschiene (QV) so in den vorderen Zentrierbereich (LS, ZL) der Führungsmittel (N, LS, ZL, GS, GL) reicht, daß die Frontplatte (FP) in Radialrichtung zentriert ist, und
b2) die Schraube (SR) in den hinteren Gewindebereich (GS, GL) der Führungsmittel (N, LS, ZL, GS, GL) einschraubbar ist.

2. Baugruppenträger nach Anspruch 1, wobei die Schraube (SR) als eine Schaftschraube (SR) mit einem Schaftteil (S) und einem Gewindeteil (G) derart ausgestaltet ist, daß
a) der Schaftteil (S) annähernd paßgenau die Frontplatte (FP) drehbar und axial beweglich durchreicht,
b) der Gewindeteil (G) bei Anlegen der Frontplatte (FP) an die Querschiene (QV) so in den vorderen Zentrierbereich (LS, ZL) der Führungsmittel (N, LS, ZL, GS, GL) reicht, daß die Frontplatte (FP) in Radialrichtung zentriert wird, und
c) der Gewindeteil (G) zusätzlich in den hinteren Gewindebereich (GS, GL) der Führungsmittel (N, LS, ZL, GS, GL) einschraubbar ist.

3. Baugruppenträger nach einem der vorangegangenen Ansprüche, wobei die Führungsmittel (N, LS, ZL, GS, GL)
a) eine Zentrierleiste (LS) aufweisen, in welcher zur Bildung des vorderen Zentrierbereichs (LS, ZL) längs in Reihe angeordnete äquidistante Zentrierlöcher (ZL) vorgesehen sind, und
b) eine Gewindeleiste (GS) aufweisen, welche hinter der Zentrierleiste (LS) angeordnet ist und in welcher zur Bildung des hinteren Gewindebereichs (GS, GL) längs in Reihe angeordnete äquidistante Gewindelöcher (GL) vorgesehen sind.

4. Baugruppenträger nach Anspruch 3, wobei die Führungsmittel (N, LS, ZL, GS, GL) eine zu der Frontplatte (FP) hin offene, profilierte Längsnut (N) in der Querschiene (QV) aufweisen, in welche die Zentrierleiste (LS) und die Gewindeleiste (GS) eingeschoben sind.

5. Baugruppenträger nach einem der vorangegangenen Ansprüche, wobei die Führungsmittel (N, LS, ZL, GS, GL) im vorderen Zentrierbereich (LS, ZL) einen Durchmesser (DD) aufweisen, welcher größer ist als der Gewindedurchmesser (dd) im hinteren Gewindebereich (GS, GL) .

6. Baugruppenträger nach einem der Ansprüche 2 bis 5, wobei der die Frontplatte (FP) durchreichende Schaftteil (S) der Schaftschraube (SR) einen Schaftdurchmesser (d) aufweist, welcher kleiner ist als der Gewindeaußendurchmesser (D) des Gewindeteils (G).

7. Baugruppenträger nach einem der Ansprüche 2 bis 6, wobei der Gewindeteil (G) der Schaftschraube (SR) einen Gewindeaußendurchmesser (D) aufweist, welcher geringfügig kleiner ist als der Durchmesser (DD) des vorderen Zentrierbereichs (LS, ZL) der Führungsmittel (N, LS, ZL, GS, GL).

## Claims

1. Subrack (BGT) with plug-in modules (BG) which are provided with a front plate (FP), and with
a) at least one front transverse section (QV) for screwing on the front plate (FP), the transverse section (QV) having guide means (N, LS, ZL, GS, GL) with in each case a front centring region (LS, ZL) and a rear threaded region (GS, GL), and with
b) at least one screw (SR) reaching through the front plate (FP) of a module (BG), at least the front plate (FP) and screw (SR) being matched with one another in such a way that
b1) upon the front plate (FP) being laid against the transverse section (QV), the screw (SR) reaches into the front centring region (LS, ZL) of the guide means (N, LS, ZL, GS, GL) such that the front plate (FP) is centred in the radial direction, and
b2) the screw (SR) can be screwed into the rear threaded region (GS, GL) of the guide means (N, LS, ZL, GS, GL).

2. Subrack according to Claim 1, in which the screw (SR) is configured as a shank screw (SR) with a shank part (S) and a threaded part (G) in such a way that
a) the shank part (S) reaches approximately true to size through the front plate (FP) in a rotatable and axially movable fashion,
b) upon the front plate (FP) being laid against the transverse section (QV), the threaded part (G) reaches into the front centring region (LS, ZL) of the guide means (N, LS, ZL, GS, GL) such that the front plate (FP) is centred in the radial direction, and
c) in addition, the threaded part (G) can be screwed into the rear threaded region (GS, GL) of the guide means (N, LS, ZL, GS, GL).

3. Subrack according to one of the preceding claims, in which the guide means (N, LS, ZL, GS, GL)
a) have a centring strip (LS) in which equidistant centring holes (ZL) arranged longitudinally in a row are provided for the purpose of forming the front centring region (LS, ZL), and
b) have a threaded strip (GS) which is arranged behind the centring strip (LS) and in which equidistant threaded holes (GL) arranged longitudinally in a row are provided for the purpose of forming the rear threaded region (GS, GL).

4. Subrack according to Claim 3, in which in the transverse section (QV) the guide means (N, LS, ZL, GS, GL) have a profiled longitudinal groove (N), open towards the front plate (FP), into which the centring strip (LS) and the threaded strip (GS) are pushed.

5. Subrack according to one of the preceding claims, in which in the front centring region (LS, ZL) the guide means (N, LS, ZL, GS, GL) have a diameter (DD) which is larger than the thread diameter (dd) in the rear threaded region (GS, GL).

6. Subrack according to one of Claims 2 to 5, in which the shank part (S), reaching through the front plate (FP), of the shank screw (SR) has a shank diameter (d) which is smaller than the thread outside diameter (D) of the threaded part (G).

7. Subrack according to one of Claims 2 to 6, in which the threaded part (G) of the shank screw (SR) has a thread outside diameter (D) which is slightly smaller than the diameter (DD) of the front centring region (LS, ZL) of the guide means (N, LS, ZL, GS, GL).

## Revendications

1. Châssis de montage (BGT) comportant des modules (BG) qui peuvent être enfichés et qui sont munis d'une plaque (FP) frontale, et comportant
a) au moins un rail (QV) transversal avant pour le vissage de la plaque (FP) frontale, le rail (QV) transversal comportant des moyens (N, LS, ZL, GS, GL) de guidage ayant chacun une zone (LS, ZL) de centrage avant et une zone (GS, GL) taraudée arrière, et comportant
b) au moins une vis (SR) traversant la plaque (FP) frontale d'un module (BG), au moins la plaque (FP) frontale et la vis (SR) étant adaptées l'une à l'autre de telle manière que
b1) la vis (SR) va, lorsque l'on applique la plaque (FP) frontale au rail (QV) transversal, dans la zone (LS, ZL) de centrage avant des moyens (N, LS, ZL, GS, GL) de guidage de telle manière que la plaque (FP) frontale est centrée dans la direction radiale, et
b2) la vis (SR) peut être vissée dans la zone (GS, GL) taraudée arrière des moyens (N, LS, ZL, GS, GL) de guidage

2. Châssis de montage suivant la revendication 1, la vis (SR) étant réalisée en vis (SR) sans tête ayant une partie (S) de tige et une partie (G) filetée de telle manière que
a) la partie (S) de tige traverse en ajustement serré la plaque (FP) frontale avec possibilité de rotation et de déplacement axial,
b) la partie (G) filetée va, lors de l'application de la plaque (FP) frontale au rail (QV) transversal, dans la zone (LS, ZL) de centrage avant des moyens (N, LS, ZL, GS, GL) de guidage de telle manière que la plaque (FP) frontale est centrée dans la direction radiale, et
c) la partie (G) filetée peut être vissée de plus dans la zone (GS, GL) taraudée arrière des moyens (N, LS, ZL, GS, GL) de guidage.

3. Châssis de montage suivant l'une des revendications précédentes, les moyens (N, LS, ZL, GS, GL) de guidage comportant
a) une baguette (LS) de centrage dans laquelle sont prévus pour former la zone (LS, ZL) de centrage avant des trous (ZL) de centrage équidistants ménagés longitudinalement les uns derrière les autres, et
b) comportant une baguette (GS) taraudée qui est montée derrière la baguette (LS) de centrage et dans laquelle sont ménagés pour former la zone (GS, GL) taraudée arrière des trous (GL) taraudés équidistants ménagés longitudinalement les uns derrière les autres.

4. Châssis de montage suivant la revendication 3, les moyens de guidage (N, LS, ZL, GS, GL) comportant une rainure (N) longitudinale profilée qui est ménagée dans le rail (QV) transversal, qui est ouverte en direction de la plaque (FP) frontale et dans laquelle sont enfilées la baguette (NS) de centrage et la baguette (GS) taraudée.

5. Châssis de montage suivant l'une des revendications précédentes, les moyens (N, LS, ZL, GS, GL) de guidage ayant dans la zone (LS, ZL) de centrage un diamètre (DD) qui est plus grand que le diamètre (dd) de taraudage dans la zone (GS, GL) taraudée arrière.

6. Châssis de montage suivant l'une des revendications 2 à 5, la partie (S) de tige de la vis (SR) sans tête traversant la plaque (FP) frontale ayant un diamètre (d) de tige qui est inférieur au diamètre (D) extérieur de filetage de la partie (G) filetée.

7. Châssis de montage suivant l'une des revendications 2 à 6, la partie (G) filetée de la vis (SR) sans tête ayant un diamètre (D) extérieur de filetage qui est légèrement inférieur au diamètre (DD) de la zone (LS, ZL) de centrage avant des moyens (N, LS, ZL, GS, GL) de guidage.
